(19) Europäisches Patentamt
European Patent Office
Office européen des brevets

(11) **EP 4 372 403 A1**

(12) **EUROPEAN PATENT APPLICATION**

(43) Date of publication:
**22.05.2024 Bulletin 2024/21**

(21) Application number: **22208511.0**

(22) Date of filing: **21.11.2022**

(51) International Patent Classification (IPC):
**G01R 33/28** (2006.01)          **G01R 33/48** (2006.01)
**G01R 33/56** (2006.01)          G01R 33/561 (2006.01)
G01R 33/563 (2006.01)

(52) Cooperative Patent Classification (CPC):
**G01R 33/288; G01R 33/4828; G01R 33/5608;**
G01R 33/481; G01R 33/4816; G01R 33/5616;
G01R 33/56375

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Siemens Healthineers AG
91301 Forchheim (DE)**

(72) Inventor: **Testud, Frederik
22467 Lund (SE)**

(74) Representative: **Siemens Healthineers
Patent Attorneys
Siemens Healthcare GmbH
SHS TE IP
Henkestraße 127
91052 Erlangen (DE)**

(54) **METHOD FOR GENERATING A SUBJECT-SPECIFIC MAP OF TISSUE PROPERTIES DURING AN MR EXAMINATION**

(57)    The invention relates to a method for generating a subject-specific map (20) of tissue properties of a region of interest within a subject, the method comprising the steps of receiving an MR image (2) of the region of interest; feeding the MR image (2) as input into at least one trained neural network (4, 6), wherein the output of the neural network (4, 6) is an output image (8, 10) having improved contrast between bone and air; segmenting (12) the output image (8, 10) into air, bone and at least one further type of tissue to obtain a segmented image (13); and assigning (14) predetermined values for the density and for at least one electromagnetic property to air, bone and each other type of tissue in the segmented image (13), to obtain a subject-specific map (20) of tissue properties. The invention is also directed to a method of estimating SAR from the map of tissue properties.

FIG 1

EP 4 372 403 A1

## Description

The invention relates to a computer-implemented method for generating a subject-specific map of tissue properties, namely the density and at least one electromagnetic property, during an MR examination of a region of interest within a subject, to a method of using the subject-specific map of tissue properties in the calculation of a subject-specific estimation of the Specific Absorption Rate for a planned MR imaging protocol, and a computer program and system for carrying out the inventive method.

According to international regulations, as set out e.g. in International Electrotechnical Commission. International standard, Medical equipment - Part 2-33: Particular requirements for the safety of Magnetic resonance equipment. International Electrotechnical Commission 60601-2-33, 2022, it is necessary to limit the specific absorption rate (SAR) in magnetic resonance (MR) examinations. The SAR is a measure for energy absorption in the tissue, caused in particular by the radiofrequency (RF) excitation pulses, which induce a highfrequency, high energy electromagnetic field in the tissue. Thereby, the tissue in the patient's body is heated up, and this heating must be limited to very strict levels to prevent tissue damage.

It is important to estimate not only the global, but the local SAR, since the RF energy is not absorbed at the same rate throughout the body, and local tissue damage must be avoided. Therefore, an accurate estimation of the local SAR would be necessary to correctly assess the safety of a magnetic resonance imaging (MRI) pulse sequence. In the MR scanners currently on the market, SAR is estimated fairly roughly and without spatial accuracy, since the prediction algorithm uses a generic model of the subject's body. In view of these rough estimates, an additional considerable safety margin is added to the SAR, to take into account the geometrical differences between the real subject and the model used. This current practice, however, leads to limitations especially at high magnetic field strength of $\geq 3$ T, and when using parallel excitation.

At least in theory, it would be possible to perform a sufficiently adequate SAR estimation for a given RF pulse, if a subject-specific model of the spatial distribution of the tissue electromagnetic properties was available. It is however challenging to create an accurate subject-specific model of the tissue properties. Originally, a non-individualised human model, for example from the virtual family disclosed in Christ A., Kainz W., Hahn E.G., et al. "The Virtual Family - development of surface-based anatomical models of two adults and two children for dosimetric simulations." Phys. Med. Biol. 2010; 55:N23-N38, was used. However, this simplification may not be good enough for subjects with an anatomy not covered by the virtual family.

Milshteyn, Eugene et al., "Individualized SAR Calculations Using Computer Vision-Based MR Segmentation and a Fast Electromagnetic Solver", Magn Reson Med, vol.85, 2021, describes a method of SAR calculations from segmented MR images. However, the different tissue types are identified using an MR-CT Atlas dictionary. In other words, the model of the tissue is not fully patient-specific, but based on standardised patient information. This naturally results in not fully patient-specific SAR calculations.

It was proposed by H. Homann et al., "Toward Individualized SAR Models and In Vivo Validation", Magn. Reson. Med., vol. 66, 2011, to generate a more patient-specific model by a whole-body MR exam, which provided fat and water volumes which were then segmented to create a muscle-fat-long model. This model, however, does not take into account bone.

Further, the prior art methods are all limited by resolution or accuracy of the model, in particular with respect to correctly labelling voxels such as bone or air. This is especially a problem when modelling the human head, because the sinuses include very small structures which provide low signal and can therefore not be assigned to bone or air using the known method.

It is therefore an object of the invention to provide an improved method for generating a subject-specific map of tissue properties during a MR examination. It is further object to generate a map of tissue properties which can distinguish well between bone and air. It is a further object of the invention to allow accurate estimation of the Specific Absorption Rate for a planned MR protocol.

These objects are fulfilled by the method according to claim 1, a computer program according to claim 14 and a system according to claim 15.

Independent of the grammatical term usage, individuals with male, female or other gender identities are included within the term.

According to first aspect of the invention, a computer-implemented method is provided for generating a subject-specific map of tissue properties during an MR examination of a region of interest within a subject, the method comprising the steps of: (a) receiving a three-dimensional MR image (2) of the region of interest; (b) feeding the MR image (2) into a trained neural network, wherein the output of the trained neural network is an output image having improved contrast between bone and air; (c) segmenting the output image into air, bone and at least one other type of tissue, in particular into fat and soft tissue, to obtain a segmented image; (d) assigning (14) pre-determined values for the density and for at least one electromagnetic property to air, bone and each other type of tissue in the segmented image, to obtain a subject-specific map of tissue properties.

In particular, step (d) comprises: assigning (14) pre-determined values for the density to air, bone and each other type of tissue in the segmented image and assigning (14) pre-determined values for at least one electromagnetic property to air, bone and each other type of tissue in the segmented image, to obtain a subject-specific map of tissue properties.

The invention is based on the insight that the different tissue types in the human body have different values for density and electromagnetic properties, which however can be estimated in advance, as they are not subject-specific, or only to a small degree. Therefore, if an image is segmented into the various tissue types and typical values for the density and electromagnetic properties for each tissue type are assigned to the segmented regions, a map of various tissue properties can be obtained. However, it has so far not been possible to automatically segment MR images in this way, because both air and bone do not give an MR signal and therefore appear exactly the same in MR images, namely having pixel values of 0, which are generally depicted as black. Therefore, if an MR image is segmented into different tissue types, it is difficult to differentiate between bone and air, especially in the head, where the sinuses include very small structures of bone and air. Bone and air have different conductivity and relative permittivity and need therefore to be considered in a model for global and local SAR estimation.

The invention uses an MR image of the region of interest and applies a trained neural network thereto, wherein an output image having improved contrast between bone and air is generated. The invention has recognised that the different tissue types can best be segmented not from MR images directly, but from images generated from MR images by trained neural networks. For example, the output image of the trained neural network (NN) may be an attenuation correction map (AC-map), which is normally used to correctly reconstruct positron emission tomography (PET) data acquired with PET-MR scanners. The AC-maps are required to account for the attenuation of the anatomical structures as well as the RF coils, which otherwise would falsify the PET measurements. The resulting AC-maps have been demonstrated to have a more accurate distribution of bones and air cavities in the head or in the rest of the body. Further, since the different tissue types air, bone, soft tissue and fat, have different AC values, an AC-map may easily be segmented into the different tissue types, for example by thresholding. Several methods have been proposed to estimate AC-maps from MR images, e.g., as described in Keereman, S. Vandenberghe, Y. De Deene, R. Luypaert, T. Broux, and I. Lemahieu, "MR-based attenuation correction for PET using an ultrashort echo time (UTE) sequence," IEEE Nucl. Sci. Symp. Conf. Rec., pp. 4656-4661, 2008, where an ultrashort echo time (UTE) sequence is used to derive the AC-map.

The MR image is preferably a three-dimensional (3D) image, although a single two-dimensional image, or several or a stack of two-dimensional (2D) images may also be used. The MR image has preferably been acquired in the same MR examination session as the MR imaging protocol for which SAR is to be estimated. It may be acquired as a localiser image used for planning further MR protocols.

The neural network may be a convolutional neural network (CNN), for example having 4 to 16 convolutional layers. The convolutional neural network may be based on an encoder-decoder structure, for example of the type as described in C. N. Ladefoged et al., "AI-driven attenuation correction for brain PET/MRI: Clinical evaluation of a dementia cohort and importance of the training group size," Neuroimage, vol. 222, p. 117221, Nov. 2020. For example, each layer in the neural network may comprise one or more 3x3x3 kernels, batch normalisation, an activation function, for example a rectified linear unit, and a dropout layer in the encoding part, and vice versa in the decoding part. Further, the CNN may have symmetric concatenations between corresponding states in the encoder and decoder sections. Alternatively, the NN may be a generative adversarial network.

The neural network may for example be as described in A. Torrado-Carvajal et al.: "DIXON-VIBE Deep Learning (DIVIDE) Pseudo-CT synthesis for Pelvis PET/MR attenuation correction" Y. Nuclear. Med 2019; 60:429-435. In this paper, a convolutional neural network with an encoder-decoder structure is used. In the encoder structure, two to three convolutional layers are followed by a max-pooling layer. The input to the NN are in-phase and opposed-phase, fat and water 2D DIXON slices, and the output is a pseudo-CT slice.

In an embodiment, the neural network is trained on the specific body part examined, for example the human head, abdomen, lung, heart or specific organs or limbs. The neural network may therefore be chosen according to the body part in which the region of interest is situated. By this smart use of artificial intelligence, the invention makes use of convolutional or generative adversarial neural networks to improve the contrast between bone and air, which otherwise does not allow suitable segmentation of the images.

The output image if the NN is segmented into air, bone and at least one other type of tissue, in particular into fat and soft tissue, to obtain a segmented image. In the simplest form, the segmentation differentiates between bone, air and soft tissue, wherein soft tissue comprises all types of soft tissue, e.g. fat, muscle, white matter, grey matter, skin, liver, cartilage, etc.. In more sophisticated embodiments, the soft tissue may also be differentiated into several different types, for example fat and soft tissue, wherein soft tissue comprises muscle, white and grey matter, connective tissue, etc. The segmentation step may use thresholding or other segmentation techniques.

In a next step, pre-determined values for tissue density and the at least one electromagnetic property, are assigned to each pixel or voxel in the segmented image, according to its type of material (bone, soft tissue or air), to obtain the subject-specific map of tissue properties. The values used for the various tissue properties can for example be taken from known databases, such as the database of the Foundation for Research on Information Technologies in Society (IT'IS, https://itis.swiss/virtual-population/tissue-properties/database/). For some electromagnetic properties like the electric conductivity and magnetic permittivity, the values vary with the frequency of the RF excitation. Therefore, the Larmor frequency of the planned MR examination has to be taken into account, which is proportional to the main magnetic field strength $B_0$ and can be calculated from $\omega = \gamma B_0$, where $\gamma$ is the gyromagnetic ratio of the nucleus used, e.g. $^1H$.

It has been shown that such a map, even if based on only air, bone and one or two other tissue types, yields very good results in calculating the corresponding Specific Absorption Rate (SAR), since it is entirely subject-specific, without making use of any atlases or other preconceived ideas about the patient's anatomy. The only predetermined values are the tissue property values of the different tissue types, which however are known and do not vary significantly from patient to patient.

The invention thereby provides an extremely fast and easily implemented method for generating a subject-specific map of various tissue properties, including tissue density.

The method of the invention is preferably performed by a computer, which may be any processing unit such as a CPU of a server or PC, or preferably a processing unit within an MR scanner. The method is preferably carried out during an MR examination of a subject, i.e., while the subject is in the sensitive region of the MR scanner. This is because the generated tissue properties map may be used to calculate the SAR in MR protocols which are to be carried out in this MR examination. The MR scanner may also be a PET/MR scanner or other hybrid device. The subject may be a human or animal, in particular a patient during an MR or MRI examination.

According to an embodiment, the method includes a further step (e) of using the subject-specific map of tissue properties and a model of the RF coil used for RF excitation in the MR examination in the calculation of the subject-specific estimation of the SAR for a planned MR imaging protocol. Thus, the RF pulses of a planned MR imaging protocol, i.e. an MR imaging sequence which is to be performed (later) on the subject during the current MR examination, are simulated using the subject-specific map of the necessary tissue properties, in order to accurately estimate the SAR, in particular the local SAR, in other words the SAR at each or at least some of the voxels within the region of interest. The SAR is preferably calculated at sufficient spatial resolution to accurately assess potential local tissue damage, e.g. at a resolution of $\leq 30$ mm$^3$, preferably $\leq 20$ mm$^3$, most preferred $\leq 10$ mm$^3$. This calculation uses the subject-specific map of tissue properties, i.e. a model of the subject. The calculation may be done by a simulation of the electromagnetic fields within the region of interest, for example using a finite-element time-domain approach. Such an approach is for example explained in A. Taflove, "Application of the Finite-Different Time-Domain method to sinusoidal Steady-State Electromagnetic-Penetration Problems", IEEE Trans. Electromagnet. Compat, Vol. EMC-22, no.3, pp.191-202, 1980. In detail, the SAR may be estimated as explained in the following:

The specific absorption rate (SAR) is proportional to the conductivity $\sigma$, the volumetric mass density $\rho$ and the square of the Euclidean norm of the electric field, see equation 3. The electric field $\vec{E}$ needs to be computed from Maxwell's equations

$$\nabla \times \vec{B} = \mu\sigma\vec{E} + \mu\epsilon\frac{\partial\vec{E}}{\partial t} \qquad \text{[Eq. 1]}$$

$$\nabla \times \vec{E} = \frac{\partial\vec{B}}{\partial t} \qquad \text{[Eq. 2]}$$

for each point in the spatio-temporal domain, in particular within the region of interest and over the time of the planned MR protocol. $\sigma$, $\varepsilon$ and $\mu$ are the conductivity, relative permittivity and the magnetic permeability, respectively. $\vec{B}$ is the magnetic field.

Solving the Maxwell equations ([Eq.1] and [Eq.2]) is a complex problem which can be solved for example by a Finite-Difference Time-Domain (FDTD) approach, as in the reference by Taflove cited above. A model of the transmit coil, i.e. the RF coil used for excitation, is required, which may be the body coil of the MR scanner used, the geometry of which is generally known. The model preferably further includes the location of capacitors, inductors, electrical characteristics of the material used for the coil, etc. The simulation further requires the subject-specific segmented model of the various tissue types. The respective $\sigma$ (conductivity), $\varepsilon$ (electric permittivity) and $\mu$ (magnetic permeability) are assigned for each tissue type, as well as the volumetric mass density $\rho$.

The subject-specific model which contains the electromagnetic properties may be placed in the RF coil model at the desired location in the simulation. The simulation space may be larger than only inside the RF coil. The simulation space may be discretized in cells where the $\vec{E}$-fields are defined on the edges and the $\vec{B}$-fields are defined on the faces.

These cells are referred to as Yee cells, as disclosed in K. S. Yee, "Numerical Solution of Initial Boundary Value Problems Involving Maxwell's Equations in Isotropic Media," IEEE Trans. Antennas Propag., vol. 14, no. 3, pp. 302-307, 1966.

The Maxwell equations, discretized in space and time, may be rewritten so that the (unknown) future fields are expressed in terms of (known) past fields values. Provided reasonable boundary conditions (absorbing outer radiation boundary conditions are commonly used in MR, for example the "perfectly matched layer" (PML) condition as disclosed in J. Berenger, "A perfectly matched layer for the absorption of electromagnetic waves", Journal of Computational Physics, vol. 114, no. 2, pp. 185-200, 1994), the field evolutions in each Yee cell and time point may be calculated iteratively by the following algorithm:

1. Evaluate the magnetic fields one time-step into the future (in the next step, they become past fields).
2. Evaluate the electric fields one time-step into the future (in the next step, they become past fields).
3. Repeat the previous steps 1 and 2 until the fields have been obtained over the desired duration

The SAR can then be estimated in each point of the spatio-temporal domain, where $\rho(\vec{r})$ is the volumetric mass density:

$$SAR(\vec{r}, t) = \frac{\sigma(\vec{r}) \left\| \vec{E}(\vec{r},t) \right\|^2}{2\,\rho(\vec{r})} \qquad [\text{Eq. 3}]$$

Alternative approaches to estimate the E and B fields may also be used, for example based on the finite element methods (FEM), as used in R. Rojas and A. O. Rodriguez, "Numerical study of the SNR and SAR of MRI coil arrays," Annu. Int. Conf. IEEE Eng. Med. Biol. - Proc., pp. 1196-1199, 2007.

According to an embodiment, the output image of the neural network is a synthetic attenuation correction map. The advantage of using attenuation correction maps (AC-maps) is that they generally consist of only a limited number of tissue types, namely bone, fat and soft tissue. Therefore, they may be particularly useful in generating models for SAR calculations, which also require only a limited number of tissue types in order to simulate the electric and magnetic fields. Also, attenuation correction maps can be estimated from MR images. In recent years, trained convolution neural networks were proposed to obtain better AC-maps than atlas-based methods, e.g., from high resolution and fast Dixon acquisitions, which can be measured within 39 seconds, all from UTE volumes with two echo times. Suitable neural networks are described in C. N. Ladefoged, L. Marner, A. Hindsholm, I. Law, L. Højgaard, and F. L. Andersen, "Deep learning based attenuation correction of PET/MRI in pediatric brain tumor patients: Evaluation in a clinical setting," Front. Neurosci., vol. 13, no. JAN, pp. 1-9, 2019. The resulting AC-maps have a more accurate distribution of bones and air cavities in the head than previous atlas-based methods. The obtained AC-maps also have a high resolution, high enough to show the detailed anatomical structure in the sinuses and to differentiate between bone and air. Thus, it is possible to deliver high-resolution attenuation correction maps from MR images using trained neural networks.

According to another embodiment, the output image of the neural network is a synthetic CT (Computed Tomography) image. The synthetic CT image may have a higher spatial resolution than the MR image. A method for transforming a low-resolution MR image into a high-resolution MR image using a CNN based network, and transforming the high-resolution MR image to a pseudo-CT image has been proposed in US 2020/0034948 A1. In this method, two convolutional neural networks are used one after the other, and the output image is suitable for segmenting into the different tissue types, because CT images distinguish very well between bone and air, so a segmentation into soft tissue, bone and air does not provide any problems. Also, CT images have a high resolution and a CNN may be trained to achieve such high resolution, even from lower resolution MR input images.

The MR image of the region of interest may be acquired by any possible MR sequence, for example spin echo, fast spin echo, gradient echo, echo planar imaging (EPI) etc. The contrast may be T1-weighted, T2-weighted or spin-density weighted. The MR image may be a morphological image, for example acquired using an MPRAGE protocol. The MR image may be three-dimensional (3D) or two-dimensional (2D), wherein the method may also be applied to a stack of 2D images. According to an embodiment, the MR image has been acquired using a fast MR imaging protocol, preferably DIXON or DIXON-VIBE protocol, MPRAGE protocol, or magnetic resonance imaging (MRI) sequences with ultrashort echo time (UTE). It is advantageous if the MR image is required within less than a minute, and the above-mentioned imaging methods allow an acquisition of a 3D image volume in about 10-60 seconds, preferably 20-40 seconds. A high-resolution 3D DIXON-VIBE protocol may be used with CAIPIRINHA acceleration, wherein high resolution may mean voxel size of $\leq 2{\times}2{\times}2$ mm$^3$, preferably $\leq 1.5{\times}1.5{\times}1.5$ mm$^3$. The acquisition may be made even shorter if an acquisition with Compressed Sensing is used, and/or the resolution is reduced. A further advantage of UTE and DIXON sequences is that they are available for clinical MR scanners at all field strengths ranging from 1.5 T to 7 T, for example for 1.5 T, 3 T and 7 T MR scanners. A further advantage is that MR images acquired using UTE and Dixon at 3 T have a good suitability to be converted for example into AC-maps using convolutional neural networks.

In an embodiment, the MR image has been acquired using a DIXON or DIXON-VIBE protocol, which generates in-phase and opposed-phase image volumes. Thus, both in-phase and opposed-phase images may be fed into the trained NN to produce the output image, e.g. an AC-map or pseudo-CT image. This allows the NN to distinguish better between fat and other tissues. Further, the MR image may be obtained using several MR acquisitions or sequences, for example by combining several MR images of the same field-of-view.

According to an embodiment, the method comprises the further steps of receiving a morphological image of the region of interest, segmenting the morphological image into at least two categories of soft tissue types to obtain a soft tissue segmented image (33), and combining the soft tissue segmented image with the segmented image (13) to obtain an improved segmented image.

The morphological image may be a morphological MR image, for example acquired by MPRAGE (Magnetization Prepared RApid Gradient Echo), which uses a non-selective inversion pulse followed by a collection of rapidly acquired gradient echoes obtained at short echo times and small flip angles. The morphological image preferably shows better contrast between different soft tissue types than the MR image to which the neural network is applied. The morphological image may also be acquired using spin echo, fast spin echo, FLASH or other MR sequences allowing a good contrast for example between grey matter and white matter in the human brain. The morphological image may be acquired in the same examination session than the MR image, but may also have been acquired previously and may then be registered with the MR image.

In a next step, the morphological image is segmented into at least two types of soft tissue, for example, grey matter, white matter and cerebral spinal fluid (CSF) in the brain. In addition, in other body areas, the types of soft tissue may include one or several of fat, muscle, liver tissue, blood, skin, lung or kidney. In MR imaging of the brain, typically the soft tissue will be segmented into at least grey matter, white matter and CSF. Thereby, the tissue density and the electromagnetic tissue properties can be estimated more accurately for soft tissue than in methods relying only on one type of MR image. The combination may be performed by replacing the soft tissue segmentation in the segmented image with the more detailed soft tissue segmentation from the soft tissue segmented image. In the next step, predetermined values for the tissue properties are assigned to each type of tissue and soft tissue in the improved segmented image to obtain the subject-specific map of tissue properties.

In an alternative, the soft tissue segmented image may also be assigned values for the tissue properties directly, and then the two tissue properties maps which are ultimately derived from the MR image and from the morphological image may be combined. The combination may be done by applying a mask to the soft tissue and using the values derived from the morphological image for the soft tissue and for all other image areas the values derived from the MR image.

According to an embodiment, the at least one electromagnetic property comprises the electrical conductivity, the relative permittivity and optionally the magnetic permeability. These are the properties which - in addition to the density - are required to accurately simulate the temporal and special evolution of the electric and magnetic fields in the region of interest during the planned MR protocol, in particular during the corresponding RF pulses.

According to an embodiment, the one or several segmentation steps is/are performed using a thresholding technique. The advantage of thresholding is that it is computationally simple, but is sufficient in the present case because the output image of the trained NN, as well as the morphological image, have sufficiently good contrast between the tissue types that are to be segmented. The segmentation may be a 3D adaptive thresholding method. Alternatively, the segmentation into the different tissue types may also be performed using model-based segmentation, atlas-based segmentation, histogram-based methods, age detection, region-growing or any other segmentation methods. The central assumption of model-based approaches is that the structures of interest have a tendency towards a particular shape. Therefore, one can seek a proper ballistic model that characterises the shape and its variation. When segmenting an image, constraints can be imposed using this model as a prior as described in L.H. Steib "Boundary finding with parametrically deformable models". IEEE Transactions of Pattern Analysis and Machine Intelligence 14 (11): 1061-1075. In a further embodiment, the segmentation may also be done using a trained neural network. In particular in the tissue segmentation of the morphological images, a NN which is trained to label different soft tissue types may be used.

According to an embodiment, the region of interest is at least partially within the head of the subject, or may comprise the human head. In other embodiments, the region of interest may include the abdomen, lung, heart or specific organs or limbs.

In an embodiment, the MR image which is fed into the trained NN is composed of at least two images which are displaced from one another in the direction of movement of a bed on which the subject is placed, wherein the at least two images have been acquired in different positions of the bed. The images may be MR images which have been acquired using one of the imaging protocols disclosed herein, but at positions which are displaced with respect to each other, in particular in an axial direction of a MR-bore, since this is the direction in which the MR bed is usually moveable. The images are preferably overlapping slightly, for example by 1 to 30%, preferably 5-20% of their individual field-of-view. This allows registration of the two or more images with one another. This embodiment is advantageous because the then resulting MR image may cover a greater overall field-of-view. This is useful in performing the SAR simulation, because the model of the body, i.e. the map of tissue properties, should extend beyond the sensitive region of the RF coil used for excitation. Thereby, the coil load for the SAR simulation is improved. If the SAR is to be calculated for a region of interest within the human head or consisting of the human head, it may be advantageous to acquire another image of the neck and shoulders. Thereby, the SAR can be calculated more accurately. Preferably, the MR images composed of two images, three images are also possible. Thereby, a head model may for example be extended by e.g. 100 to 200 mm below the field-of-view which is to be imaged.

According to an embodiment, the MR image which is fed into the trained NN has a relatively low resolution, in particular a voxel resolution $\geq 3{\times}3{\times}3$ mm$^3$, preferably $\geq 4{\times}4{\times}4$ mm$^3$. Thereby, the acquisition of the MR image can be further accelerated. The NN may be trained to accept such low-resolution MR images as input. It has been shown in the above-cited article by Milshteyn et al. that a model with a voxel resolution of only 5x5x5 mm$^3$ may produce useful results. In some embodiments, the NN is trained to output images with a higher resolution, e.g. pseudo-CT images.

According to an embodiment, the method includes a further step of assigning predetermined values for at least one thermal property to air, bone and each type of tissue in the segmented image, wherein the at least one thermal property is selected from the specific heat capacity, the thermal conductivity, the perfusion rate and the metabolic heat generation rate, and a step of performing a simulation of subject-specific changes in local body temperature during the planed MR imaging protocol at the positions of at least some voxels within the region of interest. Thus, the improved subject-specific SAR can be used as an input to perform improved simulation of subject-specific thermal changes. Thereby, not only electromagnetic properties, but also thermal properties must be assigned to the segmented image to produce a subject-specific model of thermal properties, including specific heat capacity, thermal conductivity, perfusion rate and metabolic heat generation rate. This simulation may be performed using the extended Pennes Bioheat equation, as suggested in M. Murbach et al., "Thermal tissue damage model analysed for different whole-body SAR and scan duration for standard MR body coils" Magn. Reson. Med., Vol.71, No.1, pp.421-431, 2014. The values for the thermal properties may also be taken from the above-cited free database of IT'IS.

The invention is also directed to a computer program comprising instructions which, when the program is executed by a computer, cause the computer to carry out the method described herein for generating a subject-specific map of tissue properties. The computer may be any processing unit, cloud computer or server, also a processing unit on a mobile device such as a laptop, smartphone or tablet.

The invention is also directed to a non-transient digital storage medium on which the computer program is stored. Such digital storage medium may be a hard disk, optical disk, magnetic storage medium, SD card, USB stick, CD-ROM or any possible portable or nonportable data storage medium.

The invention is also directed to a system for generating a subject-specific map of tissue properties, in particular the density and at least one electromagnetic property, of a region of interest within a subject. The system comprises a first interface, configured for receiving an MR image of the region of interest; a computational unit, configured for (a) feeding the MR image as input into at least one trained neural network, wherein the output of the neural network is an output image having improved contrast between bone and air, (b) segmenting the output image into air, bone and at least one other type of tissue in the segmented image, in particular into fat and soft tissue, to obtain a segmented image, (c) assigning pre-determined values for the density and for at least one electromagnetic property to air, bone and each other type of tissue in the segmented image, to obtain a subject-specific map of tissue properties, and a second interface, configured for providing the map of the tissue property. Every advantage and feature described with respect to the inventive method may also be applied to the system and vice versa.

The system may be part of an MR scanner, and particular part of the computer controlling the MR scanner and the image acquisition. However, the system may also be a remote computer to which the MR image is transferred.

The invention proposes to use an MR image acquisition, for example using a DIXON-VIBE protocol, to create a subject-specific model of tissue properties, in particular the electrical properties such as conductivity and permeability, and the tissue density, for at least the compartments air, bone and soft tissue. The subject-specific model is created using a neural network, for example a convolutional neural network or a generative adversarial network. Such networks have been used for PET/MR devices to obtain improved attenuation correction maps, and therefore existing NNs can be readily used in the inventive method. In summary, a truly MR-only subject-specific model of electrical properties can be used SAR estimation, in contrast to the paper by Milshteyn, where an atlas is needed and deformed to the subject geometry.

The proposed invention can make use of convolutional neural networks (CNN's) and the possibility to segment the tissue types of interest, and assigning them their corresponding tissue property values. This approach only requires moderate computational power in a reasonable amount of time, wherein a modern GPU is sufficient. The proposed approach avoids using an atlas, it only relies on MR measurements from one or several acquisitions.

The invention allows more freedom in planning MR protocols, in particular, for RF pulses at high magnetic field strength ($\geq$ 7 T), for pulses sequences using a multi-channel transmit system to perform parallel excitation at all field strengths, or when performing RF screenings at higher magnetic fields, for example $\geq$ 3 T. It is important to accurately predict the local SAR to make sure it does not surpass the allowed maximum value per 10 g tissue.

The invention will now be illustrated by means of embodiments with reference to the attached drawings. In the drawings

Fig. 1 shows a flowchart of a first embodiment of a method according to the invention.

Fig. 2 shows a flowchart of a second embodiment of the method of the invention.

Fig. 3 shows a flowchart of a trained neural network according to an embodiment of the invention.

Fig. 4 shows a schematic illustration of a trained neural network.

Fig. 5 shows a flowchart of a third embodiment of the method according to the invention.

Fig. 6 shows a flowchart of an embodiment of the SAR estimation step;

Fig. 7 shows a system according to an embodiment of the invention.

Similar features are designated with the same reference numbers in the following.

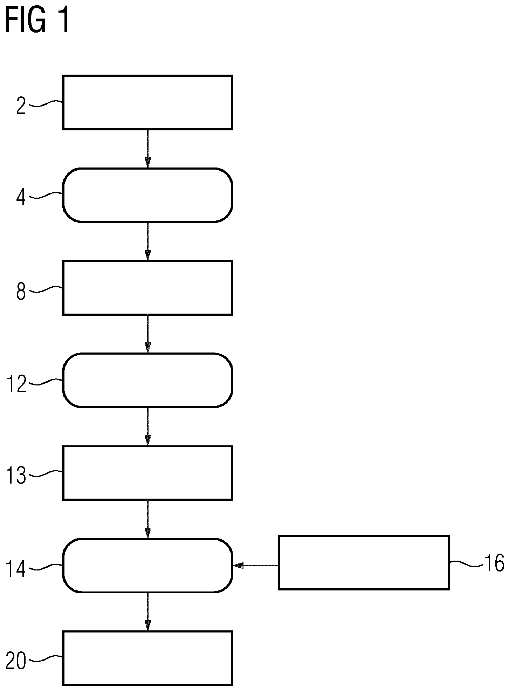

Figure 1 illustrates a method for generating a subject-specific map of tissue properties of a region of interest. As a starting point, an MR image 2 of the region of interest is fed into a trained neural network 4, wherein the MR image 2 may for example be acquired using a fast imaging protocol, for example MPRAGE. The neural network 4 converts this MR image 2 into a synthetic AC-map 8. The AC-map 8 may have the same or higher resolution than the input MR image and generally has better contrast between bone and air. In a next step 12, the AC-map 8 is segmented into at least two types of tissue, namely at least bone and a type of soft tissue, and air. For example, this step may result in a segmented image 13 in which every voxel is assigned to one of the above tissue types or air. In the next step 14, predetermined values for the tissue properties, namely the density and at least one electromagnetic property, are assigned to each type of tissue and air in the segmented image. These predetermined values are for example known from the IT'IS database and may be stored in a computer or database 16.

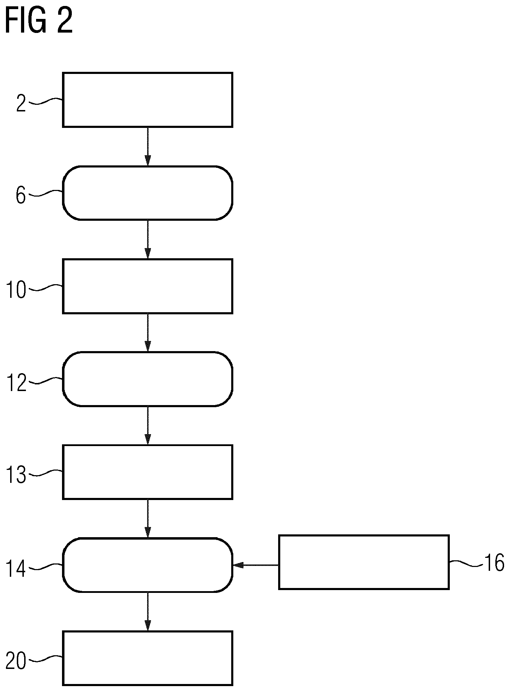

Figure 2 shows an alternative method, in which the MR image 2 is fed into a different type of trained neural network 6, which has as output image a synthetic CT image 10. Again, the synthetic CT image 10 may have high resolution and particular good contrast between bone and air, better than the input MR image. In the next step 12, the synthetic CT image 10 is segmented into different tissue types and air, resulting in the segmented image 13. In the next step 14, again predetermined values 16 for the tissue properties, namely the density and at least one electromagnetic property, are assigned to each voxel and thereby the map 20 is generated.

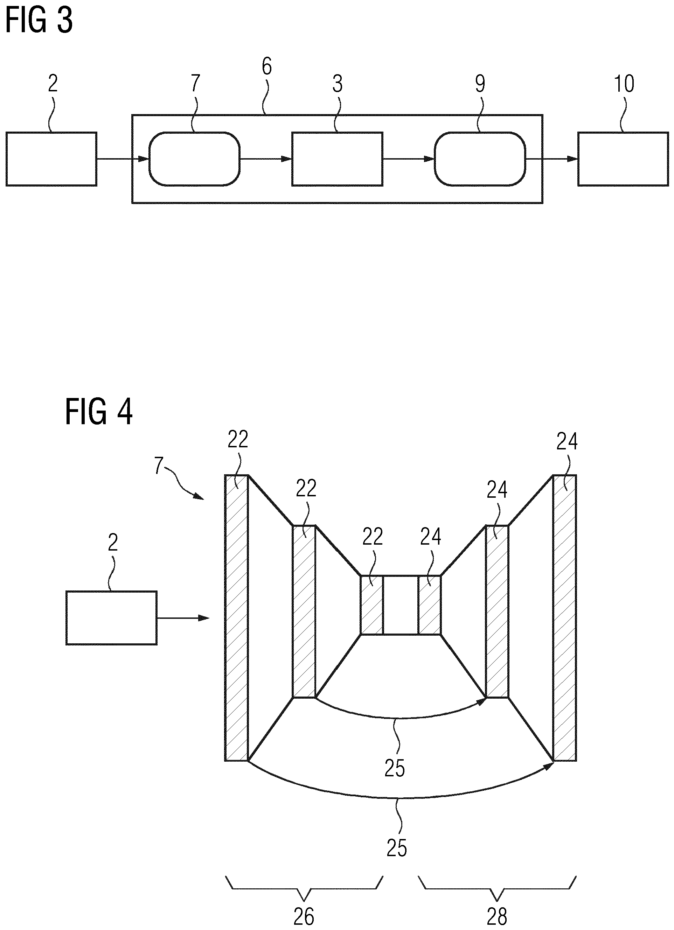

Figure 3 illustrates the trained neural network according to an embodiment in more detail. In this embodiment, the neural network 6 actually comprises two neural networks, wherein the first neural network 7 gives as output an MR image 3 of higher resolution than the input MR image 2. In the next step 9 performed by another neural network, a synthetic CT image 10 is generated.

Figure 4 illustrates a trained convolutional neural network, which may be used for the conversions described herein, it may for example be the neural network 7, but may also be an example for a neural network 4 or 8. In detail, the neural network takes the MR image 2 as input layer and comprises a number of layers 22, 24 between the input layer and the output layer to allow deep learning. The Input layer 2 may comprise more than one MR image, for example in-phase and opposed-phase images acquired by a DIXON acquisition. Thus, the input layer and the other layers may have a depth of 2 or higher. According to a preferred embodiment, the convolutional neural network 7 comprises an encoder portion 26 and a decoder portion 28. The encoder portion 26 comprises a number of layers 22, for example two to six such layers. Each layer 22 comprises the operation of one or several convolutional kernels, for example 3x3x3 kernels for a 3D input image 2, followed by an activation function, followed by a down-sampling/pooling operation, for example a MAX-pooling function. Thereby, the size of the layers is reduced going from one layer to the next in the encoder portion. Usually, several convolutions are applied, so that the layers have an increasing depth (also called more channels) from one layer 22 to the next. There may be one or several layers, which may also be fully connected layers, in the central portion between the encoder part 26 and the decoder part 28. The decoder part 28 comprises also e.g., two to eight layers 24, generally the same number of layers as the encoder portion. Each layer 24 also comprises a convolution kernel, an activation function and an up-sampling operation, so that the output layer may have the same dimensions as the input layer, although it may also have a higher or lower dimension. In addition, the neural network may comprise skip connections 25 by which the more detailed information from the encoder layers 22 is directly fed into the layers 24 of the decoder portion 28. By such a CNN, it is possible to convert MR images into pseudo-CT images or AC-maps. The CNN may be trained using real CT images as output training data and corresponding MR images as input training data, for example using a back propagation training algorithm.

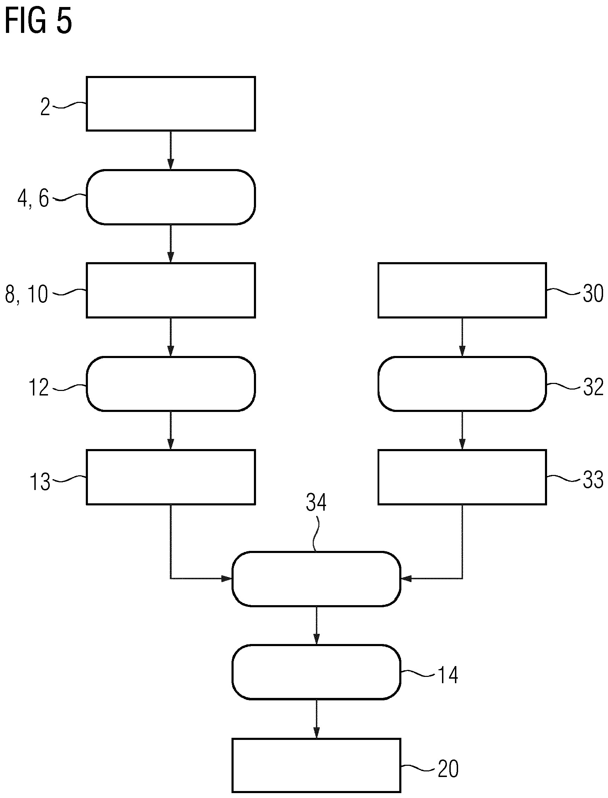

Figure 5 illustrates a method according to a further embodiment of the invention, in which a morphological image 30 is used. The left side is the same as for the embodiments of Figures 1 and 2 and includes neural networks 4 for 6 generating synthetic AC-maps or CT images 8, 10, followed by segmenting these images in step 12 into at least bone, soft tissue and air. On the right side, in addition a morphological MR image 30 of the region of interest is obtained, either from a previous or the same session, and it is used to segment different types of soft tissue in step 32, for example white matter, grey matter, skin and CFS for a head image. In step 34, the soft tissue segmented image 33 is combined with the segmented image 13 originating from the segmentation of bone, soft tissue and air in segmented image 12, so that the improved segmented image comprises more soft tissue types. This improved segmented image is then assigned predetermined values for tissue properties for each voxel in step 14 to yield the map 20.

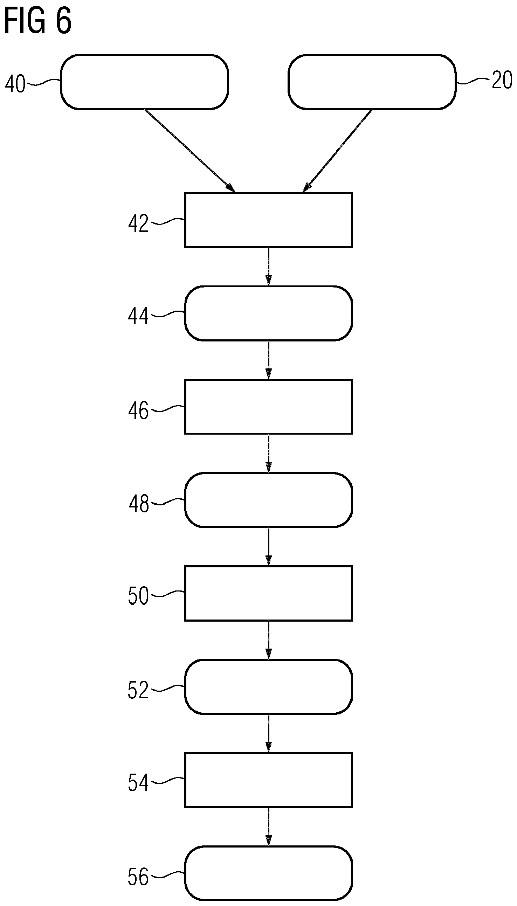

Figure 6 shows a flow-diagram of the steps required to estimate the spatial temporal SAR based on the subject-specific model of density and other tissue properties. As input to the method, the discrete RF coil geometry 40, preferably including the RF coil's properties such as electrical material properties, the correct capacitor, resistance and inductance values for the discretized elements, is. Further, the subject-specific map of tissue properties 20, in particular in the shape of a discrete model with electromagnetic properties, in particular the frequency dependent conductivity, relative permittivity and magnetic permeability, are provided. As further input, the RF pulse shape to be used in the MR protocol to be simulated is provided. The RF pulse shape may be provided in the form of a time-dependent voltage amplitude and phase for each transmit channel of the RF transmit coil used.

Both the subject-specific model 20 and the coil model 40 are placed at their respective positions, corresponding to their position in real space, in the simulation space in step 42. Thereby, a combined coil and subject-specific model in the simulation space 44 is generated. In a next step 46, this simulation space is completely divided into Yee cells, wherein the electromagnetic properties, in particular conductivity, relative permittivity and magnetic permeability are assigned to each cell, based on the provided subject-specific model 20. As boundary conditions, the E-fields may be defined on the edges of each cell, and the B-fields may be defined on the faces of each cell. Thus, the combined coil and subject-specific model 48 is obtained, discretised in Yee cells.

In step 50, an electromagnetic simulation is performed to estimate the B and E fields for each Yee cell and time point from Maxwell's equation, using a finite-difference time-domain (FDTD) approach with defined outer radiation boundary conditions. These are boundary conditions, which are set at the borders of the simulation space (which is spatially finite), and which specify how the electromagnetic field behaves at the borders. For example, the outer radiation boundary conditions may specify whether the electromagnetic field is reflected or absorbed at the boundaries. For example, one may use the PML [J. Berenger, 1994] conditions, as quoted above, in which the electromagnetic waves are absorbed.

In details, the steps may be:

1. Calculate the curl of the B-field from equation 1 at time $T_{n-1}$ under the given boundary conditions.

2. Calculate the E-field using equation 1 from the curl of the B-field estimated in step 1 at time $T_{n-1}$.

3. Calculate the curl of the E-field from equation 2 using the E-field estimated in step 2 at Time $T_n$.

4. Estimate the B-field from equation 2.

This results in the spatiotemporal E- and B-fields 52. From these spatial and temporal E- and B-fields, the specific absorption rate may be estimated for each voxel from the E-field, the tissue density and the conductivity, using the above equation 3, in step 54. Thereby, a spatiotemporal SAR 56, based on the subject-specific model, may be obtained with a high special resolution, in particular the same special resolution as the map of tissue properties 20.

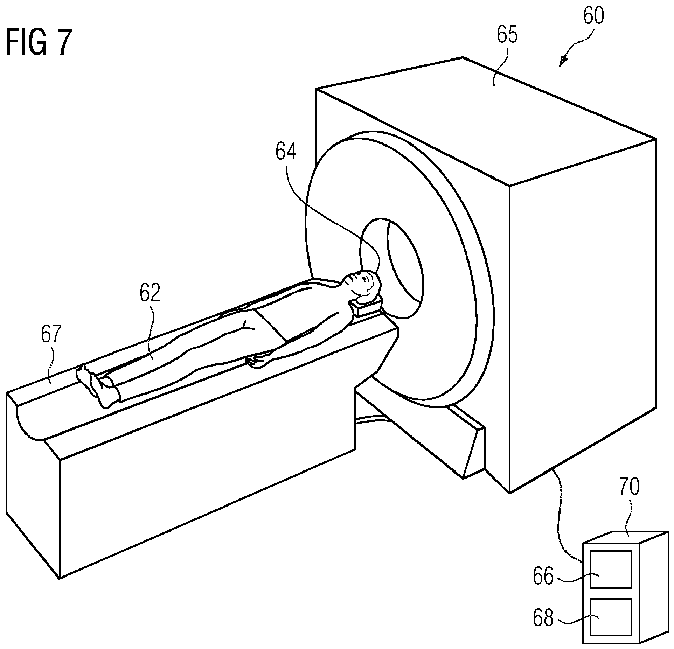

Figure 7 finally illustrates a system 60 for carrying out the method according to the invention. The system 60 in this case is an MR scanner comprising a main magnet 65 and a patient bed 67. A patient 62 is lying on the patient bed, while her head 64 is being imaged. The MR scanner 60 is connected to a computer 70 comprising at least a CPU 66 and a data storage 68. The computer 70 may be the computer generally controlling the MR acquisition of the MR scanner 60 and is adapted to perform the method according to embodiments of the invention.

**Claims**

1. A computer-implemented method for generating a subject-specific map of tissue properties during an MR examination of a region of interest within a subject (62), the method comprising the steps of:

    (a) receiving a three-dimensional MR image (2) of the region of interest;

(b) feeding the MR image (2) into a trained neural network (4, 6), wherein the output of the trained neural network is an output image (8, 10) having improved contrast between bone and air;
(c) segmenting (12) the output image (8, 10) into air, bone and at least one other type of tissue, in particular into fat and soft tissue, to obtain a segmented image (13) ;
(d) assigning (14) pre-determined values (16) for the density and for at least one electromagnetic property to air, bone and each other type of tissue in the segmented image (13) to obtain a subject-specific map (20) of tissue properties.

2. The method of claim 1, comprising a further step (e) of using the subject-specific map of tissue properties (20) and a model (40) of the RF coil used for RF excitation in the MR examination in the calculation of a subject-specific estimation of the Specific Absorption Rate (54) for a planned MR imaging protocol.

3. The method of claim 1 or 2, wherein the output image of the trained neural network (4, 6) is a synthetic CT image (10) or a synthetic attenuation correction map (8).

4. The method one of the preceding claims, wherein the MR image (2) has been acquired using a fast MR imaging protocol.

5. The method of claim 4, wherein the fast MR imaging protocol is a DIXON imaging protocol, MPRAGE imaging protocol or an imaging protocol with ultrashort echo time.

6. The method of one of the preceding claims, wherein the method comprises the further steps of

- receiving a morphological image (30) of the region of interest, in particular a T1-weighted MPRAGE image,
- segmenting (32) the morphological image (30) into at least two types of soft tissue to obtain a soft tissue segmentated image (13),
- combining (34) the soft tissue segmented image (33) with the segmented image (13) to obtain an improved segmented image, and using the improved segmented image as the segmented image in step (d).

7. The method of one of the preceding claims, wherein the at least one electromagnetic property comprises the electrical conductivity, the relative permittivity and optionally the magnetic permeability.

8. The method of one of the preceding claims, wherein the segmenting step(s) (12, 32) is/are performed using a thresholding technique.

9. The method of one of the preceding claims, wherein the MR image (2) of the region of interest is a 3D image acquired with a DIXON-VIBE imaging sequence and comprises in-phase and opposed-phase image volumes, wherein both in-phase and opposed-phase image volumes are input into the trained neural network.

10. The method of one of the preceding claims, wherein the MR image (2) is composed of at least two images which are displaced from one another in the direction of movement of a bed on which the subject is placed, wherein the at least two images have been acquired in different positions of the bed.

11. The method of one of the preceding claims, wherein the region of interest is at least partially within the head (64) of the subject (62).

12. The method of one of the preceding claims 2 to 11, wherein the step of using the subject-specific map of tissue properties and a model of the RF coil in the calculation of a subject-specific estimation of the Specific Absorption Rate comprises

- placing the subject-specific map of tissue properties, the tissue properties including conductivity, electric permittivity and magnetic permeability, and the model of the RF coil, at locations corresponding to their real locations in a simulation space,
- dividing the simulation space into a Yee lattice composed of Yee cells,
- providing boundary conditions for the electric and magnetic fields
- performing electromagnetic simulation to estimate the magnetic and electric fields in each Yee cell for discrete time points during the planned MR imaging protocol, in particular using a Finite-Difference Time-Domain approach, resulting in spatial temporal electric fields,

- estimating the Specific Absorption Rate for at least some voxels within the region of interest from the spatial temporal electric field, the density and the conductivity at the respective voxel position.

13. The method of one of the preceding claims 2 to 12, including a further step of

- assigning pre-determined values for at least one thermal property to air, bone and each type of tissue in the segmented image, wherein the at least one thermal property is selected from the specific heat capacity, the thermal conductivity, the perfusion rate, and the metabolic heat generation rate,
- performing a simulation of subject-specific changes in local body temperature during the planned MR imaging protocol at the positions of at least some voxels within the region of interest.

14. A computer program comprising instructions which, when the program is executed by a computer (70), cause the computer to carry out the method of one of the claims 1 to 13.

15. A system for generating a subject-specific map of tissue properties during an MR examination of a region of interest within a subject (62), the system comprising:

a first interface, configured for receiving an MR image (2) of the region of interest;
a computational unit, configured for

- feeding the MR image (2) as input into at least one trained neural network (4, 6), wherein the output of the neural network (4, 6) is an output image (8, 10) having improved contrast between bone and air;
- segmenting (12) the output image (8, 10) into air, bone and at least one other type of tissue in the segmented image, in particular into fat and soft tissue, to obtain a segmented image (13);
- assigning (14) pre-determined values for the density and for at least one electromagnetic property to air, bone and each other type of tissue in the segmented image (13) to obtain a subject-specific map (20) of tissue properties; and

a second interface, configured for providing the map (20) of the tissue properties.

FIG 1

# FIG 2

# FIG 3

# FIG 4

FIG 5

# FIG 6

FIG 7

Europäisches
Patentamt

European
Patent Office

Office européen
des brevets

# EUROPEAN SEARCH REPORT

**Application Number**

EP 22 20 8511

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | MILSHTEYN EUGENE ET AL: "Individualized SAR calculations using computer vision-based MR segmentation and a fast electromagnetic solver", MAGNETIC RESONANCE IN MEDICINE, vol. 85, no. 1, 8 July 2020 (2020-07-08), pages 429-443, XP093038922, US ISSN: 0740-3194, DOI: 10.1002/mrm.28398 Retrieved from the Internet: URL:https://onlinelibrary.wiley.com/doi/full-xml/10.1002/mrm.28398> | 1-8,10, 11,13-15 | INV. G01R33/28 G01R33/48 G01R33/56  ADD. G01R33/561 G01R33/563 |
| Y | * entire document, in particular section 2 and the last paragraphs of sections 1 and 4; figures 1,2,3 * | 9,12 | |
| Y,D | ANGEL TORRADO-CARVAJAL ET AL: "Dixon-VIBE Deep Learning (DIVIDE) Pseudo-CT Synthesis for Pelvis PET/MR Attenuation Correction", THE JOURNAL OF NUCLEAR MEDICINE, vol. 60, no. 3, 30 August 2018 (2018-08-30), pages 429-435, XP055752887, US ISSN: 0161-5505, DOI: 10.2967/jnumed.118.209288 * abstract; page 430 - page 431 * | 9,12 | |

-/--

| | |
|---|---|
| | **TECHNICAL FIELDS SEARCHED (IPC)** |
| | G01R |

The present search report has been drawn up for all claims

| Place of search | Date of completion of the search | Examiner |
|---|---|---|
| Munich | 14 April 2023 | Lebar, Andrija |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

# EUROPEAN SEARCH REPORT

Application Number

EP 22 20 8511

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | ANDREAS CHRIST ET AL: "NOTE; The Virtual Family-development of surface-based anatomical models of two adults and two children for dosimetric simulations; The virtual family---development of surface-based anatomical models of two adults and two children for dosimetric simulations", PHYSICS IN MEDICINE AND BIOLOGY, INSTITUTE OF PHYSICS PUBLISHING, BRISTOL GB, vol. 55, no. 2, 21 January 2010 (2010-01-21), pages N23-N38, XP020167091, ISSN: 0031-9155 * third paragraph of section 1 * ----- | 12 | |

TECHNICAL FIELDS
SEARCHED      (IPC)

The present search report has been drawn up for all claims

| Place of search | Date of completion of the search | Examiner |
|---|---|---|
| Munich | 14 April 2023 | Lebar, Andrija |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20200034948 A1

### Non-patent literature cited in the description

- **CHRIST A. ; KAINZ W. ; HAHN E.G. et al.** The Virtual Family - development of surface-based anatomical models of two adults and two children for dosimetric simulations. *Phys. Med. Biol.,* 2010, vol. 55, N23-N38
- **MILSHTEYN, EUGENE et al.** Individualized SAR Calculations Using Computer Vision-Based MR Segmentation and a Fast Electromagnetic Solver. *Magn Reson Med,* 2021, vol. 85
- **H. HOMANN et al.** Toward Individualized SAR Models and In Vivo Validation. *Magn. Reson. Med.,* 2011, vol. 66
- **KEEREMAN ; S. VANDENBERGHE ; Y. DE DEENE ; R. LUYPAERT ; T. BROUX ; I. LEMA-HIEU.** MR-based attenuation correction for PET using an ultrashort echo time (UTE) sequence. *IEEE Nucl. Sci. Symp. Conf. Rec.,* 2008, 4656-4661
- **C. N. LADEFOGED et al.** AI-driven attenuation correction for brain PET/MRI: Clinical evaluation of a dementia cohort and importance of the training group size. *Neuroimage,* November 2020, vol. 222, 117221
- **A. TORRADO-CARVAJAL et al.** DIXON-VIBE Deep Learning (DIVIDE) Pseudo-CT synthesis for Pelvis PET/MR attenuation correction. *Y. Nuclear. Med,* 2019, vol. 60, 429-435
- *Foundation for Research on Information Technologies in Society, https://itis.swiss/virtual-population/tissue-properties/database/*

- **A. TAFLOVE.** Application of the Finite-Different Time-Domain method to sinusoidal Steady-State Electromagnetic-Penetration Problems. *IEEE Trans. Electromagnet. Compat,* 1980, vol. EMC-22 (3), 191-202
- **K. S. YEE.** Numerical Solution of Initial Boundary Value Problems Involving Maxwell's Equations in Isotropic Media. *IEEE Trans. Antennas Propag.,* 1966, vol. 14 (3), 302-307
- **J. BERENGER.** A perfectly matched layer for the absorption of electromagnetic waves. *Journal of Computational Physics,* 1994, vol. 114 (2), 185-200
- **R. ROJAS ; A. O. RODRIGUEZ.** Numerical study of the SNR and SAR of MRI coil arrays. *Annu. Int. Conf. IEEE Eng. Med. Biol. - Proc.,* 2007, 1196-1199
- **C. N. LADEFOGED ; L. MARNER ; A. HINDSHOLM ; I. LAW ; L. HØJGAARD ; F. L. ANDERSEN.** Deep learning based attenuation correction of PET/MRI in pediatric brain tumor patients: Evaluation in a clinical setting,. *Front. Neurosci.,* 2019, vol. 13 (JAN), 1-9
- **L.H. STEIB.** Boundary finding with parametrically deformable models. *IEEE Transactions of Pattern Analysis and Machine Intelligence,* vol. 14 (11), 1061-1075
- **M. MURBACH et al.** Thermal tissue damage model analysed for different whole-body SAR and scan duration for standard MR body coils. *Magn. Reson. Med.,* 2014, vol. 71 (1), 421-431